# EUROPÄISCHE PATENTSCHRIFT

(11) **EP 2 773 930 B1**
(45) Veröffentlichungstag und Bekanntmachung des Hinweises auf die Patenterteilung: **28.01.2015**
(21) Anmeldenummer: 11794061.9
(22) Anmeldetag: 21.11.2011
(51) Int. Cl.: H02M 1/32, G01R 31/42, G01K 7/01, G01R 31/26, G01R 31/28

(54) **ELEKTRONISCHE ANSTEUERSCHALTUNG MIT LEISTUNGSTRANSISTOREN SOWIE VERFAHREN ZUR LEBENSDAUER-ÜBERWACHUNG DER LEISTUNGSTRANSISTOREN**
ELECTRONIC CONTROL CIRCUIT WITH POWER TRANSISTORS AND METHOD FOR MONITORING LIFE SPAN OF THE POWER TRANSISTORS
CIRCUIT DE COMMANDE ELECTRONIQUE AVEC DES TRANSISTORS DE PUISSANCE ET PROCÉDÉ DE SURVEILLANCE DE LA DURÉE DE VIE DES TRANSISTORS DE PUISSANCE

(43) Veröffentlichungstag der Anmeldung: 10.09.2014
(73) Patentinhaber: EBM-Papst Mulfingen GmbH&CO. KG, 74673 Mulfingen (DE)
(72) Erfinder: LIPP, Helmut, 74677 Dörzbach-Hohebach (DE); HAAS, Günter, 74673 Mulfingen (DE); BÜRKERT, Martin, 74677 Dörzbach-Hohebach (DE)
(74) Vertreter: Peter, Julian
(86) Internationale Anmeldenummer: PCT/EP2011/070594
(87) Internationale Veröffentlichungsnummer: WO 2013/075733

(56) Entgegenhaltungen:
- EP-A2- 0 795 756
- DE-A1- 10 351 843
- DE-A1- 19 600 807
- DE-A1- 19 851 186
- DE-A1-102010 000 875

## Beschreibung

Die vorliegende Erfindung betrifft gemäß dem Oberbegriff des Anspruchs 1 eine elektronische Ansteuerschaltung für ein elektrisches Gerät, insbesondere in einer Ausbildung als Kommutierungselektronik eines EG-Motors, mit mehreren Leistungstransistoren, die in einem Betriebsmodus zum Ansteuern des Gerätes gesteuert werden.

Ferner betrifft die Erfindung auch ein neuartiges Verfahren zum Überwachen der Leistungstransistoren einer solchen Ansteuerschaltung hinsichtlich ihrer Lebensdauer.

Elektronische Ansteuerschaltungen sind in zahlreichen Ausführungen bekannt. Im Falle der bevorzugten Ausgestaltung als Kommutierungselektronik eines EG-Motors, d.h. eines kollektorlosen, elektronisch kommutierten Elektromotors, sind in aller Regel vier oder sechs Leistungstransistoren zu einer Brücken-Endstufe zusammengeschaltet, wobei die Endstufe aus einem Gleichspannungs-Zwischenkreis gespeist wird. Die einzelnen Leistungstransistoren werden von einer Steuereinheit so angesteuert, dass die Motorwicklungen derart in Abhängigkeit von der Drehstellung eines Rotors angesteuert werden, dass ein magnetisches Drehfeld zur Drehung des Rotors erzeugt wird. Insofern wirkt die Endstufe praktisch als Wechselrichter, wobei auch eine PWM-Taktung zur Drehzahleinstellung erfolgen kann.

Ansteuerschaltungen sind außerdem auch allgemein als Wechselrichter oder Frequenzumrichter für andere Verwendungen bekannt.

Die DE10351843A1 offenbart eine elektronische Ansteuerschaltung für ein elektrisches Gerät mit mehreren Leistungstransistoren, die in einem Betriebsmodus zum Ansteuern des Gerätes gesteuert werden. Aus der DE102010000875A1 ist ein Verfahren zur Messung der Junction-Temperatur bei Leistungshalbleitern in einem Stromrichter bekannt. Ferner offenbart die EP0795756A1 ein Verfahren zur Abschätzung der Lebensdauer eines Leistungshalbleiter-Bauelements.

Die Leistungstransistoren können entweder als diskrete Bauelemente auf einem Träger, z. B. einer Leiterplatte, angeordnet oder in einem Modul auf einem gemeinsamen Substrat integriert sein. Zudem können sie auf einem Kühlkörper angeordnet und z.B. als Bipolartransistoren, IGBT's oder MOSFET's ausgeführt sein.

Theoretisch unterliegen Halbleiterbauelemente keiner Lebensdauer-Beschränkung. In der Praxis kommt es aber dennoch zu Alterungsprozessen und Totalausfällen von Leistungstransistoren, d.h. Halbleiterbauteile haben im praktischen Einsatz erfahrungsgemäß eine endliche Lebensdauer.

Der vorliegenden Erfindung liegt daher die Aufgabe zu Grunde, Mittel zu schaffen, um den Alterungsprozess von Leistungstransistoren überwachen und ein nahes Ende der Lebensdauer feststellen und signalisieren zu können.

Erfindungsgemäß wird dies bei einer Ansteuerschaltung gemäß dem unabhängigen Anspruch 1 erreicht durch einen zusätzlichen, gleichartigen, im Betriebsmodus der Leistungstransistoren unbelasteten Referenztransistor, der zusammen mit den Leistungstransistoren auf einem gemeinsamen Träger oder Substrat angeordnet oder gebildet ist, sowie durch Mittel zum Beaufschlagen des Referenztransistors und mindestens eines der Leistungstransistoren in einem Testmodus mit jeweils einem Prüfstrom und zum Messen der jeweils zugehörigen Sättigungsspannung sowie zum Auswerten einer aus den gemessenen Sättigungsspannungen des Referenztransistors und des jeweiligen Leistungstransistors resultierenden Sättigungsspannungsdifferenz unter Berücksichtigung der während der Messung herrschenden Träger-/Substrat- Temperatur als Kriterium für einen Alterungsprozess und eine - anhand von Erfahrungswerten - noch zu erwartende Rest-Lebensdauer der Leistungstransistoren, wobei zusätzliche Mittel zum Erfassen und Auswerten einer Änderungsgeschwindigkeit der jeweils in aufeinanderfolgenden Testmodi erfassten Sättigungsspannungsdifferenzen als zusätzliches Kriterium für den Fortschritt des Alterungsprozesses vorgesehen sind. Dabei wird die Änderungsgeschwindigkeit pro Zeiteinheit oder pro Lastwechsel berücksichtigt.

Ein neuartiges Verfahren zum Überwachen von Leistungstransistoren in einer solchen elektronischen Ansteuerschaltung hinsichtlich ihrer zu erwartenden Rest-Lebensdauer ist Gegenstand des unabhängigen Anspruchs 9, wonach in einem Testmodus der Ansteuerschaltung für mindestens einen der Leistungstransistoren dessen Sättigungsspannung gemessen und mit der ebenfalls unter gleichen Umgebungsbedingungen gemessenen Sättigungsspannung eines zusätzlichen, gleichartigen, zusammen mit den Leistungstransistoren auf einem gemeinsamen Träger oder Substrat vorgesehenen, in einem Betriebsmodus der Ansteuerschaltung unbelasteten Referenztransistor verglichen wird, wobei eine daraus resultierende Sättigungsspannungsdifferenz unter Berücksichtigung der während der Messung vorhandenen Temperatur des Trägers (z. B. Kühlkörpers) oder des Substrats als Kriterium für den Fortschritt eines Alterungsprozesses und für die noch zu erwartende Rest-Lebensdauer der Leistungstransistoren anhand von zuvor empirisch ermittelten und gespeicherten Erfahrungswerten ausgewertet wird. Vorzugsweise wird zusätzlich eine Änderungsgeschwindigkeit der jeweils in nacheinander durchgeführten Testmodi erfassten Sättigungsspannungsdifferenzen erfasst und als Kriterium für die Rest-Lebensdauer ausgewertet, wobei zusätzlich eine Änderungsgeschwindigkeit der jeweils in nacheinander durchgeführten Testmodi erfassten Sättigungsspannungsdifferenzen erfasst und als Kriterium für die Rest-Lebensdauer ausgewertet wird.

Weitere vorteilhafte Ausgestaltungen und Weiterbildungen der Erfindung sind in den jeweils abhängigen Ansprüchen 2 bis 8 und 10 bis 15 sowie auch in der nachfolgenden Beschreibung enthalten.

Die Erfindung basiert auf der Erkenntnis, dass vor allem die Einbettung eines Halbleiter-Chip in ein Gehäuse und die elektrischen Anbindungen des Chip an die eigentlichen äußeren Bauteil-Anschlüsse wesentliche, die Lebensdauer beeinflussende Faktoren sind. Zwei Hauptfaktoren sind dabei einerseits die so genannten Bondungen an der Chip-Oberseite sowie andererseits die Lötverbindungen des Chip auf einer elektrisch leitenden "Unterlage", die beispielsweise ein lead frame oder eine Cu-kaschierte Keramik sein kann. Diese Lötverbindungen werden durch unterschiedliche thermische Ausdehnungen von Chip, Lot und jeweiliger Unterlage mit jedem Lastzyklus gestresst. Je schneller ein Temperaturanstieg im Chip während eines Lastwechsel ausfällt, umso größer wird die mechanische Stress-Belastung im Bereich der Lötungen, und umso stärker der Einfluss auf die Lebensdauer dieser Verbindungen. Die wiederholten Stress-Belastungen führen zu Delaminationen des Halbleiter-Chip von der Unterlage, wobei diese Delaminationen von den Kanten des Chip zum Mittelpunkt hin auf der Unterseite des Chip fortschreiten. Durch die zunehmende Delamination wird insbesondere der thermische Widerstand der Lötverbindungen höher. Deshalb steigt bei gleicher Verlustleistung die Absoluttemperatur des Chip mit zunehmender Lastzyklenzahl immer weiter an. Übersteigt diese Temperatur eine maximal zulässige Chiptemperatur von in aller Regel 150° bis 175°C kommt es zur Zerstörung des Halbleiter-Chip. Weiterhin wurde erkannt, dass die Sättigungsspannung, d.h. die Kollektor-Emitter-Spannung im voll durchgesteuerten Zustand des Transistors, direkt abhängig ist von Strom und Temperatur. Je höher die Chip-Temperatur ist, umso höher ist auch die Sättigungsspannung.

Erfindungsgemäß wird daher in eigens dazu vorgesehenen Testphasen - außerhalb des eigentlichen Betriebs der Ansteuerschaltung - jeweils die Sättigungsspannung gemessen und mit einem Initialwert verglichen, um dadurch über die Betriebs- und Lebensdauer hinweg eine Änderung zu erfassen, die als Kriterium für den zuvor beschriebenen Alterungsprozess genutzt wird, und zwar anhand von zuvor empirisch ermittelten, in einer Steuereinheit abgespeicherten Erfahrungswerten. Hierbei wird vorteilhafterweise als Initialwert die jeweils aktuell unter denselben Umgebungsbedingungen gemessene Sättigungsspannung des Referenztransistors verwendet. Der Vergleich der Messwerte bezogen auf das Referenzbauteil erspart vorteilhafterweise die Notwendigkeit einer hochgenauen Temperaturerfassung der einzelnen Bauteile, da die Sättigungsspannung ja temperaturabhängig ist. Vorteilhafterweise ist daher eine "grobe" Temperatur-Erfassung ausreichend; es braucht nur festgestellt zu werden, in welchem Temperaturbereich die Temperatur des Trägers, z. B. eines vorhandenen Kühlkörpers, oder des gemeinsamen Substrates während der jeweiligen Messung liegt. Die in der Steuereinheit abgespeicherten Erfahrungswerte sind bestimmten Temperaturbereichen zugeordnet, weil die Sättigungsspannungen und die erfassten Differenzen ja auch temperaturabhängig sind. So fallen bei geringen Temperaturen die Differenzen anders aus als bei höheren Temperaturen (abhängig vom Temperaturkoeffizienten des verwendeten Bauteils bezüglich seiner Sättigungsspannung). Die Lebensdauer-Erfahrungswerte werden dann aus gespeicherten Tabellen für den jeweiligen Temperaturbereich anhand der jeweils ermittelten Sättigungsspannungsdifferenz und bevorzugt auch der jeweiligen Änderungsgeschwindigkeit pro Zeiteinheit oder pro Lastwechsel entnommen und für die Auswertung und Signalisierung der voraussichtlichen Rest-Lebensdauer berücksichtigt.

Erfindungsgemäß wird zudem davon ausgegangen, dass die Veränderung der Sättigungsspannung über die Lebenszeit an den Leistungstransistoren der Ansteuerschaltung in etwa gleichartig verläuft, der Referenztransistor aber durch die deutlich reduzierte bzw. nicht vorhandene Betriebsbelastung annähernd bei seinen Initialwerten bleibt und über die Lebensdauer der Ansteuerschaltung somit als neuwertig angesehen werden kann.

Deshalb ist es grundsätzlich ausreichend, bei der erfindungsgemäßen Messung und Auswertung nur einen von mehreren vorhandenen Leistungstransistoren zu berücksichtigen. Bevorzugt werden aber alle oder zumindest mehrere Leistungstransistoren in die Prüfung einbezogen, wobei der Leistungstransistor mit der größten Sättigungsspannungsdifferenz und/oder der höchsten Änderungsgeschwindigkeit als maßgeblich für den Fortschritt des Alterungsprozesses und für die noch zu erwartende Rest-Lebensdauer der Leistungstransistoren und somit der gesamten Ansteuerschaltung betrachtet wird, weil ja bei Ausfall nur eines Leistungstransistors die gesamte Ansteuerschaltung ausfällt.

Die gemessenen Sättigungsspannungen werden beispielsweise einem Mikrocontroller zur Auswertung zugeführt. Die dadurch ermittelte Differenz zwischen den gemessenen Sättigungsspannungen bzw. deren Änderungsgeschwindigkeit gibt Aufschluss über den Fortschritt des Alterungsprozesses der Lötverbindungen zwischen Chip und Unterlage, d.h. über die Delamination. Erfahrungswerte kennzeichnen dann das unmittelbar bevorstehende Lebensdauerende bzw. die noch zu erwartende Restlebensdauer.

Voraussetzungen für die Erfindung sind:
- Die Leistungstransistoren und der Referenztransistor müssen als Modul auf einem gemeinsamen Substrat oder als Einzelbauteile auf einer gemeinsamen Leiterplatte integriert sein.
- Die Leistungstransistoren und der Referenztransistor müssen stets unter gleichen Umgebungsbedingungen stehen, beispielsweise Temperatur, Vibration, Schockbeanspruchungen.

Der erfindungsgemäße Testmodus kann beispielsweise vor jedem Start des eigentlichen Betriebsmodus der Ansteuerschaltung durchgeführt werden und/oder in vorher festgelegten, regelmäßigen oder auch unregelmäßigen Zeitintervallen unter Unterbrechung des Betriebsmodus. Der Testmodus wird jeweils über eine Steuereinheit ausgelöst und durchgeführt. Zusätzlich erfolgt eine Erfassung der Temperatur der gesamten Anordnung zur Einbindung in die Auswertung, d.h. die jeweilige Bauteil-, Substrat- oder Kühlkörper-Temperatur wird kombinatorisch in den Auswertungsprozess mit einbezogen.

Anhand der Zeichnungen und am Beispiel einer Ansteuerschaltung für einen EC-Motor soll die Erfindung im Folgenden genauer erläutert werden. Dabei zeigen:
- Fig. 1: ein Schaltbild der Ansteuerschaltung mit dem erfindungsgemäßen, zusätzlichen Referenztransistor,
- Fig. 2 und 3: Schaltbilder ähnlich Fig. 1 in zwei verschiedenen Varianten mit zeitlich nacheinander durchgeführten Messungen der Sättigungsspannungen und
- Fig. 4 und 5: weitere Schaltbilder in zwei verschiedenen Varianten mit gleichzeitiger Messung der Sättigungsspannungen.

In den verschiedenen Figuren der Zeichnung sind gleiche Teile stets mit den gleichen Bezugszeichen versehen.

Zu der anschließenden Beschreibung wird ausdrücklich betont, dass die Erfindung nicht auf die Ausführungsbeispiele und dabei nicht auf alle oder mehrere Merkmale von beschriebenen Merkmalskombinationen beschränkt ist, vielmehr kann jedes einzelne Teilmerkmal des/jedes Ausführungsbeispiels auch losgelöst von allen anderen im Zusammenhang damit beschriebenen Teilmerkmalen für sich und auch in Kombination mit beliebigen Merkmalen eines anderen Ausführungsbeispiels sowie auch unabhängig von den Merkmalskombinationen und Rückbeziehungen der Ansprüche eine erfinderische Bedeutung haben.

In den dargestellten Ausführungsbeispielen ist eine elektronische Ansteuerschaltung 1 als Kommutierungselektronik 2 eines EC-Motors M ausgebildet, wobei der Motor M dreisträngig mit drei Motor- bzw. Statorwicklungen U, V, W ausgeführt sein kann. Grundsätzlich ist auch eine einsträngige Ausführung möglich. Sonstige Bestandteile des Motors M, wie sein Rotor, sind in den Zeichnungsfiguren nicht dargestellt.

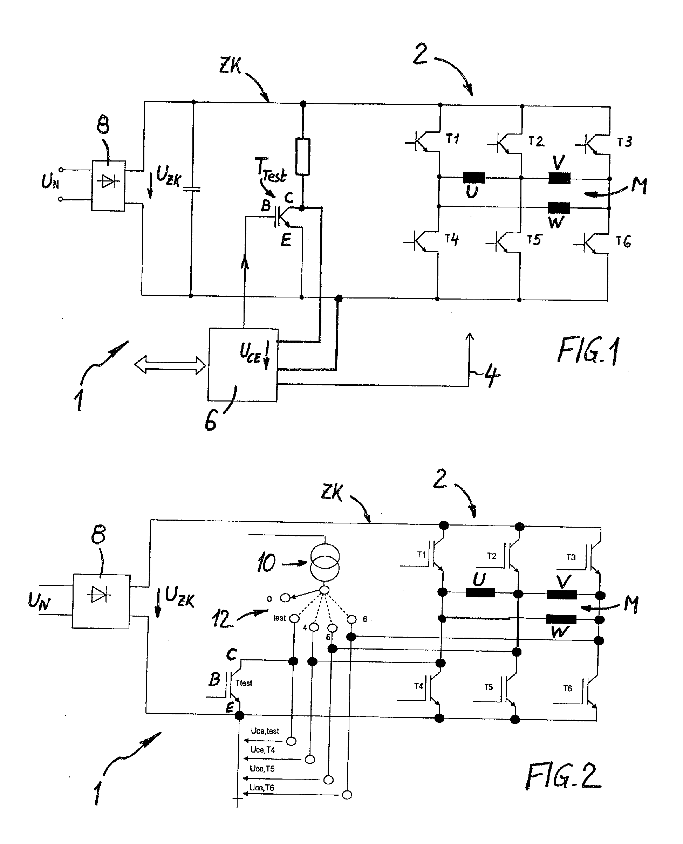

Bei der dreisträngigen Ausführung können die Wicklungen U, V, W - wie beispielhaft dargestellt ist - in Dreieckschaltung, alternativ aber natürlich auch in Sternschaltung verschaltet sein. Zur Ansteuerung sind hierbei sechs Leistungstransistoren T1 bis T6 in einer Brücken-Endstufe vorgesehen, wobei in jedem von drei parallelen Brückenzweigen zwei Leistungstransistoren in Reihe liegen und die Wicklungen U, V, W jeweils zwischen den Leistungstransistoren an die Brückenzweige angeschlossen sind. Wie nur in Fig. 1 stark vereinfacht durch einen Pfeil 4 angedeutet ist, werden die Leistungstransistoren T1 bis T6 von einer elektronischen Steuereinheit 6 zur Kommutierung angesteuert, um ein magnetisches Drehfeld für den Rotor zu erzeugen. Zusätzlich kann auch eine PWM-Taktung zur Einstellung oder Regelung der MotorDrehzahl erfolgen. Diese Kommutierungssteuerung ist allgemein bekannt und bedarf hier keiner weiteren Erläuterung.

Die Wicklungen U, V, W werden über die Endstufe üblicherweise aus einem Gleichspannungs-Zwischenkreis ZK versorgt, wobei die Zwischenkreisspannung U_{ZK} über einen Gleichrichter 8 aus einer ein- oder dreiphasigen Netzspannung U_{N} bereitgestellt werden kann. Die Endstufe mit den Leistungstransistoren T1 bis T6 wirkt somit als gesteuerter Wechselrichter.

Der Vollständigkeit halber sei erwähnt, dass für eine einsträngige Motor-Ausführung eine Brückenschaltung mit vier Leistungstransistoren in zwei Brückenzweigen ausreicht.

Erfindungsgemäß weist die Ansteuerschaltung 1 - zusätzlich zu den Leistungstransistoren T1 bis T6 - einen weiteren, gleichartigen Leistungstransistor als Referenztransistor Tₜₑₛₜ auf. Dieser Referenztransistor Tₜₑₛₜ hat in einem normalen Betriebsmodus der Ansteuerschaltung 1 keine Funktion, so dass er unbelastet und daher auch keiner lastbedingten Alterung unterworfen ist. Allerdings ist der Referenztransistor Tₜₑₛₜ zusammen mit den Leistungstransistoren T1 bis T6 auf einem gemeinsamen Träger-Substrat, Leiterplatte und/oder Kühlkörper - angeordnet, d.h. er kann in einem Leistungsmodul auf derselben Keramik integriert sein oder als Einzelbauteil auf demselben Träger sitzen. Dadurch ist er den gleichen Umgebungsbedingungen, wie insbesondere Temperatur und mechanischen Einflüssen, wie die Leistungstransistoren T1 bis T6 ausgesetzt.

Weiterhin ist die Steuereinheit 6 derart ausgelegt, dass sie in einem Testmodus der Ansteuerschaltung 1 - vor dem eigentlichen Betriebsmodus oder diesen unterbrechend - den Referenztransistor Tₜₑₛₜ und mindestens einen der Leistungstransistoren T1 bis T6 ansteuert und jeweils mit einem Prüfstrom beaufschlagt, um die jeweilige Sättigungsspannung, und zwar die Kollektor-Emitter-Spannung U_{CE} im voll durchgesteuerten Zustand zu messen. Durch Vergleich der Messwerte wird eine Sättigungsspannungsdifferenz ermittelt, die - anhand von zuvor empirisch ermittelten und in der Steuereinheit 6 gespeicherten Erfahrungswerten - als Kriterium für einen Alterungsprozess und eine noch zu erwartende Rest-Lebensdauer der Leistungstransistoren T1 bis T6 ausgewertet wird. Es wird zusätzlich über mehrere aufeinanderfolgende Testphasen ermittelt, mit welcher Änderungsgeschwindigkeit pro Zeiteinheit oder pro Lastwechsel sich die jeweiligen Sättigungsspannungsdifferenzen verändern, und die jeweilige Änderungsgeschwindigkeit wird als weiteres wichtiges Kriterium für den Alterungsprozess mit in die Auswertung einbezogen.

Bei den Ausführungsbeispielen gemäß Fig. 2 bis 5 wird die jeweilige Sättigungsspannung an mehreren der Leistungstransistoren gemessen, und zwar insbesondere an jeweils mindestens einem Leistungstransistor jedes Brückenzweiges. Bevorzugt erfolgt die Messung aufgrund der einfacheren Messbarkeit an den so genannten Lowside-Transistoren T4, T5, T6. Dadurch werden die Sättigungsspannungen U_{CET4}, U_{CET5} und U_{CET6} gemessen und mit der Sättigungsspannung U_{CEtest} des Referenztransistor Tₜₑₛₜ verglichen. Werden mehrere oder sogar alle vorhandenen Leistungstransistoren in die Messung und Auswertung einbezogen, so ist derjenige Leistungstransistor für den Fortschritt des Alterungsprozesses maßgeblich, bei dem die größte Sättigungsspannungsdifferenz und/oder die höchste Änderungsgeschwindigkeit festgestellt wird, weil ja mit Ausfall nur eines - des "schlechtesten" - Leistungstransistors die gesamte Ansteuerschaltung ausfällt.

Bei der Ausführung gemäß Fig. 2 wird der jeweilige Transistor zur Beaufschlagung mit dem Prüfstrom mit einer Konstantstromquelle 10 verbunden. Bei dieser Ausführung gemäß Fig. 2 erfolgen die Messungen zeitlich nacheinander über einen Umschalter 12.

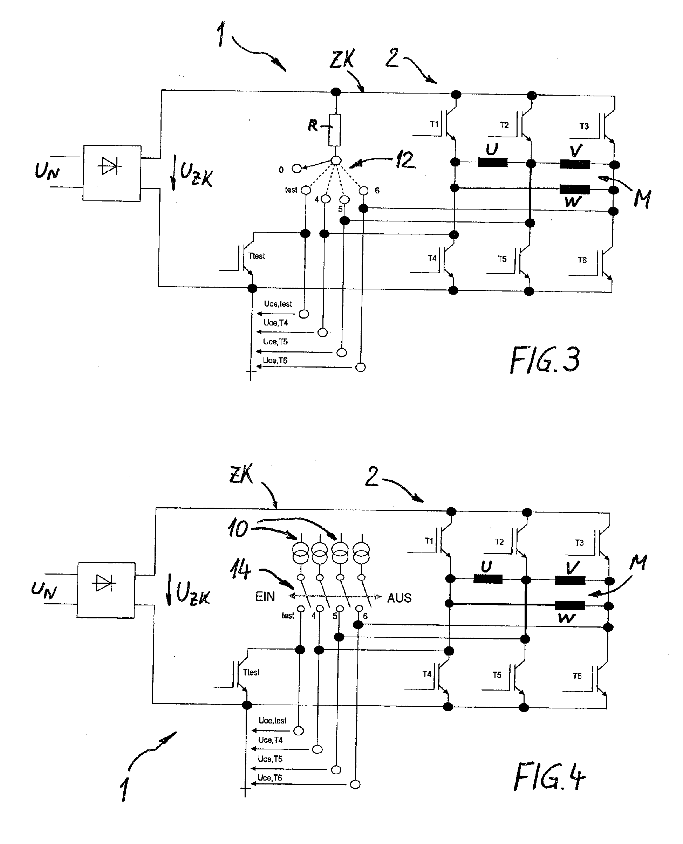

Bei der Ausführung gemäß Fig. 3 werden die jeweiligen Transistoren zur Beaufschlagung mit dem Prüfstrom über einen Widerstand R mit dem Gleichspannungs-Zwischenkreis ZK verbunden, wobei gemäß Fig. 3 die Messungen - analog zu Fig. 2 - zeitlich nacheinander über den Umschalter 12 erfolgen.

Bei der weiteren Variante nach Fig. 4 werden alle zu messenden Transistoren über einen Mehrfachschalter 14 gleichzeitig mit dem jeweiligen Prüfstrom beaufschlagt, wobei für jeden Transistor eine eigene gleichartige Konstantstromquelle 10 vorgesehen ist.

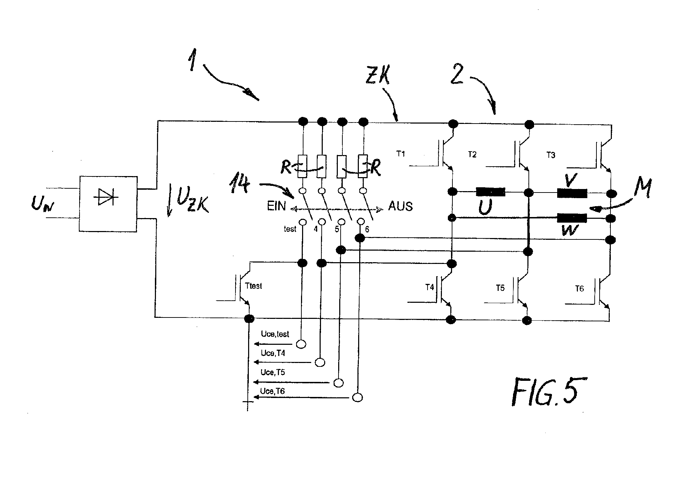

Schließlich ist auch bei der Ausführung gemäß Fig. 5 eine gleichzeitige Messung über den Mehrfachschalter 14 vorgesehen, wobei der Prüfstrom für jeden Transistor aus dem Zwischenkreis ZK über je einen gleichen Widerstand R zugeführt wird.

Im Falle der Ausführungen gemäß Fig. 4 und 5 handelt es sich um eine parallele Mehrfachmessung mit gleichzeitiger Bestimmung der einzelnen Sättigungsspannungen und Spannungsdifferenzen.

Die Steuereinheit 6 weist nicht dargestellte Speichermittel zum tabellenartigen Hinterlegen von bestimmten Erfahrungswerten der Sättigungsspannungsdifferenzen und bevorzugt von deren Änderungsgeschwindigkeit pro Zeit oder pro Lastwechsel unter Zuordnung zur Substrat-/Kühlkörpertemperatur während der Messung und zu bestimmten Zuständen eines Alterungsprozesses der Leistungstransistoren T1 bis T6 auf. Dadurch kann anhand der jeweils in dem/jedem Testmodus ermittelten Sättigungsspannungsdifferenzen und/oder der über mehrere Testmodi ermittelten Änderungsgeschwindigkeit sowie unter Berücksichtigung der jeweiligen Temperatur auf das Stadium des Alterungsprozesses und somit auch auf die noch zu erwartende Rest-Lebensdauer geschlossen werden.

Die erfindungsgemäße Ansteuerschaltung 1 weist zweckmäßige Mittel zum Anzeigen der Rest-Lebensdauer und/oder zum Erzeugen eines optischen und/oder akustischen Warnsignals für einen bevorstehenden Ausfall mindestens eines der Leistungstransistoren T1 bis T6 auf.

Variationen und Modifikationen sind möglich im Rahmen der beigefügten Patentansprüchen.

## Patentansprüche

1. Elektronische Ansteuerschaltung (1) für ein elektrisches Gerät, insbesondere in einer Ausbildung als Kommutierungselektronik (2) eines EC-Motors (M), mit mehreren Leistungstransistoren (T1 - T6), die in einem Betriebsmodus zum Ansteuern des Gerätes gesteuert werden, **gekennzeichnet durch** einen zusätzlichen, gleichartigen, im Betriebsmodus der Leistungstransistoren (T1 - T6) unbelasteten Referenztransistor (Tₜₑₛₜ), der zusammen mit den Leistungstransistoren (T1 - T6) auf einem gemeinsamen Träger oder Substrat angeordnet oder gebildet ist, sowie **durch** Mittel zum Beaufschlagen des Referenztransistors (Tₜₑₛₜ) und mindestens eines der Leistungstransistoren (T1 - T6) in einem Testmodus mit jeweils einem Prüfstrom und zum Messen der jeweils zugehörigen Sättigungsspannung (U_{CE sat}) sowie zum Auswerten einer aus den gemessenen Sättigungsspannungen (U_{CE sat}) des Referenztransistors (Tₜₑₛₜ) und des jeweiligen Leistungstransistors (T1 - T6) resultierenden Sättigungsspannungsdifferenz unter Berücksichtigung der während der Messung herrschenden Träger-/Substrat-Temperatur als Kriterium für einen Alterungsprozess und eine noch zu erwartende Rest-Lebensdauer der Leistungstransistoren (T1 - T6), wobei zusätzlich Mittel zum Auswerten einer Änderungsgeschwindigkeit der jeweils in nacheinander durchgeführten Testmodi erfassten Sättigungsspannungsdifferenzen vorhanden sind.

2. Ansteuerschaltung nach Anspruch 1, **gekennzeichnet durch** eine elektronische Steuereinheit (6) zum Auslösen und Durchführen des jeweiligen Testmodus.

3. Ansteuerschaltung nach einem der Ansprüche 1 bis 2, **dadurch gekennzeichnet, dass** der jeweilige Leistungstransistor (T1 - T6) und der Referenztransistor (Tₜₑₛₜ) zur Beaufschlagung mit dem Prüfstrom mit einer Konstantstromquelle (10) oder über einen Widerstand (R) mit einem Gleichspannungs-Zwischenkreis (ZK) verbindbar sind.

4. Ansteuerschaltung nach einem der Ansprüche 1 bis 3, **dadurch gekennzeichnet, dass** die Transistoren (T1 - T6, Tₜₑₛₜ) über einen Umschalter (12) einzeln zeitlich nacheinander mit dem Prüfstrom beaufschlagbar sind.

5. Ansteuerschaltung nach einem der Ansprüche 1 bis 3, **dadurch gekennzeichnet, dass** die Transistoren (T1 - T6, Tₜₑₛₜ) über einen Mehrfachschalter (14) gleichzeitig mit dem jeweiligen Prüfstrom beaufschlagbar sind.

6. Ansteuerschaltung nach einem der Ansprüche 1 bis 5, **gekennzeichnet durch** Speichermittel zum Hinterlegen von bestimmten Erfahrungswerten der Sättigungsspannungsdifferenz und vorzugsweise deren Änderungsgeschwindigkeit unter Zuordnung zu bestimmten Zuständen eines Alterungsprozesses der Leistungstransistoren (T1 - T6) und unter Berücksichtigung der Träger-/SubstratTemperatur.

7. Ansteuerschaltung nach einem der Ansprüche 1 bis 6, **gekennzeichnet durch** Mittel zum Anzeigen der Rest-Lebensdauer und/oder zum Erzeugen eines Warnsignals für einen bevorstehenden Ausfall mindestens eines der Leistungstransistoren (T1 - T6).

8. Ansteuerschaltung nach einem der Ansprüche 1 bis 7, **dadurch gekennzeichnet, dass** vier oder sechs Leistungstransistoren (T1 - T6) jeweils paarweise in Reihe in zueinander parallelen Brückenzweigen einer Brückenschaltung angeordnet sind, wobei in dem/jedem Testmodus an mindestens einem der beiden Leistungstransistoren (T4 - T6) jedes Brückenzweiges, insbesondere nur an dem so genannten Lowside-Transistor jedes Brückenzweiges, die Sättigungsspannung gemessen und diese in die Auswertung einbezogen wird.

9. Verfahren zum Überwachen von Leistungstransistoren (T1 - T6) in einer elektronischen Ansteuerschaltung (1) für ein elektrisches Gerät, insbesondere in einer Kommutierungselektronik (2) eines EC-Motors (M), hinsichtlich ihrer zu erwartenden Rest-Lebensdauer, wobei in einem Testmodus der Ansteuerschaltung (1) für mindestens einen der Leistungstransistoren (T1 - T6) dessen Sättigungsspannung (U_{CE}) gemessen und mit der ebenfalls unter gleichen Bedingungen gemessenen Sättigungsspannung (U_{CE test}) eines zusätzlichen, gleichartigen, zusammen mit den Leistungstransistoren (T1 - T6) auf einem gemeinsamen Träger oder Substrat vorgesehenen, in einem Betriebsmodus der Ansteuerschaltung (1) unbelasteten Referenztransistors (Tₜₑₛₜ) verglichen wird, wobei eine daraus resultierende Sättigungsspannungsdifferenz unter Berücksichtigung der während der Messung herrschenden Träger-/Substrat-Temperatur als Kriterium für den Fortschritt eines Alterungsprozesses und für die noch zu erwartende Rest-Lebensdauer der Leistungstransistoren (T1 - T6) ausgewertet wird, wobei zusätzlich eine Änderungsgeschwindigkeit der jeweils in nacheinander durchgeführten Testmodi erfassten Sättigungsspannungsdifferenzen erfasst und als Kriterium für die Rest-Lebensdauer ausgewertet wird.

10. Verfahren nach Anspruch 9, wobei die jeweils ermittelte Sättigungsspannungsdifferenz und vorzugsweise deren Änderungsgeschwindigkeit mit gespeicherten, einen Alterungsprozess charakterisierenden Erfahrungswerten unter Berücksichtigung der Träger/Substrat-Temperatur verglichen wird.

11. Verfahren nach einem der Ansprüche 9 bis 10, wobei anhand der Auswertung der jeweiligen Sättigungsspannung bei Erreichen eines bestimmten Wertes der Sättigungsspannungsdifferenz und/oder deren Änderungsgeschwindigkeit ein Signal zur Anzeige der Rest-Lebensdauer und/oder eines bevorstehenden Endes der Lebensdauer der Leistungstransistoren (T1 - T6) generiert wird.

12. Verfahren nach einem der Ansprüche 9 bis 11, wobei der Testmodus von einer Steuereinheit (6) vor jedem Betrieb der Ansteuerschaltung (1) und/oder in bestimmten Zeitabständen während des Betriebs durch Umschalten aus dem Betriebsmodus ausgelöst und durchgeführt wird, und wobei nach dem/jedem Testmodus in den Betriebsmodus umgeschaltet wird.

13. Verfahren nach einem der Ansprüche 9 bis 12, wobei im Testmodus jeweils für mehrere Leistungstransistoren (T4, T5, T6) der Ansteuerschaltung (1) deren Sättigungsspannungen (U_{CE}) gemessen werden, wobei der Leistungstransistor mit der größten Sättigungsspannungsdifferenz und/oder der höchsten Änderungsgeschwindigkeit als maßgeblich für den Fortschritt des Alterungsprozesses und die noch zu erwartende RestLebensdauer der Leistungstransistoren (T1 - T6) betrachtet wird.

14. Verfahren nach einem der Ansprüche 9 bis 13, wobei die Messungen der Sättigungsspannungen (U_{CE}) der Leistungstransistoren (T4 - T6) und des Referenztransistors (Tₜₑₛₜ) zeitlich nacheinander oder gleichzeitig erfolgen.

15. Verfahren nach einem der Ansprüche 9 bis 14, wobei im Testmodus der jeweilige Leistungstransistor (T4 - T6) und der Referenztransistors (Tₜₑₛₜ) gleichartig mit einem Prüfstrom aus einer Konstantstromquelle (10) oder über einen Widerstand (R) aus einem Gleichspannungs-Zwischenkreis (ZK) beaufschlagt werden.

## Claims

1. Electronic control circuit (1) for an electrical device, in particular designed as a commutation electronic system (2) of an EC motor (M), having a plurality of power transistors (T1 - T6), which are controlled in an operating mode to control the device, **characterised by** an additional, similar reference transistor (Tₜₑₛₜ) which is non-charged in the operating mode of the power transistors (T1 - T6) and is arranged or formed together with the power transistors (T1 - T6) on a common support or substrate, and by means for applying to the reference transistor (Tₜₑₛₜ) and at least one of the power transistors (T1 - T6) respectively a test current in a test mode and for measuring the respective associated saturation voltage (U_{CE sat}) and for evaluating a saturation voltage difference resulting from the measured saturation voltages (U_{CE sat}) of the reference transistor (Tₜₑₛₜ) and the respective power transistor (T1 - T6) taking into account the prevailing temperature of the support/substrate during the measurement as a criterion for an ageing process and an expected remaining service life of the power transistors (T1 - T6), wherein additional means for evaluating a rate of change of the saturation voltage differences recorded in each of the respective consecutive test modes are provided.

2. Control circuit according to claim 1, **characterised by** an electronic control unit (6) to trigger and perform the respective test mode.

3. Control circuit according to any one of claims 1 to 2, **characterised in that** the respective power transistor (T1 - T6) and the reference transistor (Tₜₑₛₜ) may be connected to a constant current source (10) in order to be supplied with the test current or to a DC voltage intermediate circuit (ZK) via a resistor (R).

4. Control circuit according to any one of claims 1 to 3, **characterised in that** the transistors (T1 - T6, Tₜₑₛₜ) can be supplied individually and consecutively with the test current via a commutator (12).

5. Control circuit according to any one of claims 1 to 3, **characterised in that** the transistors (T1 - T6, Tₜₑₛₜ) can be supplied simultaneously with the respective test current via a multiple switch (14).

6. Control circuit according to any one of claims 1 to 5, **characterised by** storage means to store certain empirical values of the saturation voltage difference and preferably its rate of change assigning them to certain stages of an ageing process of the power transistors (T1 - T6) and taking into account the temperature of the support/substrate.

7. Control circuit according to any one of claims 1 to 6, **characterised by** means to display the remaining service life and/or to generate a warning signal for an impending failure of at least one of the power transistors (T1 - T6).

8. Control circuit according to any one of claims 1 to 7, **characterised in that** four or six power transistors (T1 - T6) are arranged in series in pairs on respective bridge branches, which are parallel to each other, of a bridge circuit, the saturation voltage being measured in the/each test mode on at least one of the two power transistors (T4 - T6) of each bridge branch, in particular only on the so-called low side transistors of each bridge branch, and included in the evaluation.

9. Method for monitoring power transistors (T1 - T6) in an electronic control circuit (1) for an electrical device, in particular in a commutation electronic system (2) of an EC motor (M), with respect to the expected remaining service life, wherein the saturation voltage (U_{CE}) for at least one of the power transistors (T1 - T6) is measured in a test mode of the control circuit (1) and compared to the saturation voltage (U_{CE test}) of an additional similar, reference transistor (Tₜₑₛₜ), which is non-charged in the operating mode of the control circuit (1) and is arranged or formed together with the power transistors (T1 - T6) on a common support or substrate, likewise measured under the same conditions, wherein a resultant saturation voltage difference is evaluated, taking into account the prevailing temperature of the support/substrate during the measurement as a criterion for the advance of the ageing process and for the expected remaining service life of the power transistors (T1 - T6), wherein a rate of change of the saturation voltage differences is also recorded in the respective test modes, which are carried out consecutively, and evaluated as a criterion for the remaining service life.

10. Method according claim 9, wherein the respectively determined saturation voltage differences and preferably their rates of change are compared to stored empirical values characterising an ageing process, taking into account the temperature of the support/substrate.

11. Method according to any one of claims 9 to 10, wherein a signal for displaying the remaining service life and/or an impending end to the service life of the power transistors (T1 - T6) is generated with reference to the evaluation of the respective saturation voltage when a certain value of the saturation voltage difference and/or its rate of change is reached.

12. Method according to any one of claims 9 to 11, wherein the test mode of a control unit (6) is triggered and carried out before every operation of the control circuit (1) and/or at certain intervals during operation by switching from the operating mode, and wherein switching to the operating mode takes place subsequent to the/each test mode.

13. Method according to any one of claims 9 to 12, wherein the saturation voltages (U_{CE}) of each of a plurality of power transistors (T4, T5, T6) of the control circuit (1) are measured in the test mode, wherein the power transistor with the greatest saturation voltage difference and/or the highest rate of change is regarded as definitive for the advance of the ageing process and the expected remaining service life of the power transistors (T1 - T6).

14. Method according to any one of claims 9 to 13, wherein the measurements of the saturation voltages (U_{CE}) of the power transistors (T4 - T6) and of the reference transistor (Tₜₑₛₜ) are carried out consecutively or simultaneously.

15. Method according to any one of claims 9 to 14, wherein the respective power transistor (T4 - T6) and the reference transistor (Tₜₑₛₜ) are supplied similarly with a test current from a constant current source (10) or from a DC voltage intermediate circuit (ZK) via a resistor (R).

## Revendications

1. Circuit de commande électronique (1) pour un dispositif électrique, en particulier conçu sous la forme d'un système électronique de commutation (2) d'un moteur EC (M), ayant une pluralité de transistors de puissance (T1 - T6), qui sont commandés dans un mode de fonctionnement pour commander le dispositif, **caractérisé par** un transistor de référence similaire supplémentaire (Tₜₑₛₜ) qui est non chargé dans le mode de fonctionnement des transistors de puissance (T1 - T6) et qui est agencé ou formé conjointement avec les transistors de puissance (T1 - T6) sur un support ou un substrat commun, et par un moyen d'application au transistor de référence (Tₜₑₛₜ) et à au moins l'un des transistors de puissance (T1 - T6) respectivement d'un courant de test dans un mode de test, un moyen de mesure de la tension de saturation associée respective (U_{CE sat}) et un moyen d'évaluation d'une différence de tension de saturation résultant des tensions de saturation mesurées (U_{CE sat}) du transistor de référence (Tₜₑₛₜ) et du transistor de puissance respectif (T1 - T6) en prenant en compte la température régnante du support/substrat pendant la mesure en tant que critère pour un processus de vieillissement et une durée de vie restante attendue des transistors de puissance (T1 - T6), dans lequel des moyens supplémentaires d'évaluation d'un taux de changement des différences de tension de saturation enregistré dans chacun des modes de test consécutifs respectifs sont prévus.

2. Circuit de commande selon la revendication 1, **caractérisé par** une unité de commande électronique (6) pour déclencher et exécuter le mode de test respectif.

3. Circuit de commande selon l'une quelconque des revendications 1 à 2, **caractérisé en ce que** le transistor de puissance respectif (T1 - T6) et le transistor de référence (Tₜₑₛₜ) peuvent être connectés à une source de courant constant (10) afin d'être alimentés avec le courant de test ou à un circuit intermédiaire à tension continue (ZK) via une résistance (R).

4. Circuit de commande selon l'une quelconque des revendications 1 à 3, **caractérisé en ce que** les transistors (T1 - T6, Tₜₑₛₜ) peuvent être alimentés individuellement et consécutivement avec le courant de test via un commutateur (12).

5. Circuit de commande selon l'une quelconque des revendications 1 à 3, **caractérisé en ce que** les transistors (T1 - T6, Tₜₑₛₜ) peuvent être alimentés simultanément avec le courant de test respectif via un commutateur multiple (14).

6. Circuit de commande selon l'une quelconque des revendications 1 à 5, **caractérisé par** un moyen de stockage pour stocker certaines valeurs empiriques de la différence de tension de saturation et de préférence son taux de changement en les attribuant à certaines étapes d'un processus de vieillissement des transistors de puissance (T1 - T6) et en prenant en compte la température du support/substrat.

7. Circuit de commande selon l'une quelconque des revendications 1 à 6, **caractérisé par** un moyen d'affichage de la durée de vie restante et/ou de génération d'un signal d'avertissement pour une défaillance imminente d'au moins l'un des transistors de puissance (T1 - T6).

8. Circuit de commande selon l'une quelconque des revendications 1 à 7, **caractérisé en ce que** quatre ou six transistors de puissance (T1 - T6) sont agencés en série par paires sur des branches de pont respectives, qui sont parallèles l'une à l'autre, d'un circuit en pont, la tension de saturation étant mesurée dans le/chaque mode de test sur au moins l'un des deux transistors de puissance (T4 - T6) de chaque branche de pont, en particulier seulement sur lesdits transistors côté bas de chaque branche de pont, et compris dans l'évaluation.

9. Procédé de surveillance de transistors de puissance (T1 - T6) dans un circuit de commande électronique (1) pour un dispositif électrique, en particulier dans un système électronique de commutation (2) d'un moteur EC (M), par rapport à la durée de vie restante attendue, dans lequel la tension de saturation (U_{CE}) pour au moins l'un des transistors de puissance (T1 - T6) est mesurée dans un mode de test du circuit de commande (1) et comparée à la tension de saturation (U_{CE test}) d'un transistor de référence similaire supplémentaire (Tₜₑₛₜ), qui est non chargé dans le mode de fonctionnement du circuit de commande (1) et qui est agencé ou formé conjointement avec les transistors de puissance (T1 - T6) sur un support ou un substrat commun, mesuré également dans les mêmes conditions, dans lequel une différence de tension de saturation résultante est évaluée, en prenant en compte la température régnante du support/substrat pendant la mesure en tant que critère pour la progression du processus de vieillissement et pour la durée de vie restante attendue des transistors de puissance (T1 - T6), dans lequel un taux de changement des différences de tension de saturation est également enregistré dans les modes de test respectifs, qui sont réalisés consécutivement, et évalués en tant que critère pour la durée de vie restante.

10. Procédé selon la revendication 9, dans lequel les différences de tension de saturation déterminées respectivement et de préférence leurs taux de changement sont comparés à des valeurs empiriques stockées caractérisant un processus de vieillissement, en prenant en compte la température du support/substrat.

11. Procédé selon l'une quelconque des revendications 9 à 10, dans lequel un signal d'affichage de la durée de vie restante et/ou d'une fin imminente de la durée de vie des transistors de puissance (T1 - T6) est généré par rapport à l'évaluation de la tension de saturation respective lorsqu'une certaine valeur de la différence de tension de saturation et/ou de son taux de changement est atteinte.

12. Procédé selon l'une quelconque des revendications 9 à 11, dans lequel le mode de test d'une unité de commande (6) est déclenché et réalisé avant chaque fonctionnement du circuit de commande (1) et/ou à certains intervalles pendant le fonctionnement en effectuant une commutation à partir du mode de fonctionnement, et dans lequel la commutation sur le mode de fonctionnement a lieu après le/chaque mode de test.

13. Procédé selon l'une quelconque des revendications 9 à 12, dans lequel les tensions de saturation (U_{CE}) de chacune de la pluralité de transistors de puissance (T4, T5, T6) du circuit de commande (1) sont mesurées dans le mode de test, dans lequel le transistor de puissance avec la plus grande différence de tension de saturation et/ou le taux de changement le plus élevé est considéré comme définitif pour la progression du processus de vieillissement et de la durée de vie restante attendue des transistors de puissance (T1 - T6).

14. Procédé selon l'une quelconque des revendications 9 à 13, dans lequel les mesures des tensions de saturation (U_{CE}) des transistors de puissance (T4 - T6) et du transistor de référence (Tₜₑₛₜ) sont réalisées consécutivement ou simultanément.

15. Procédé selon l'une quelconque des revendications 9 à 14, dans lequel le transistor de puissance respectif (T4 - T6) et le transistor de référence (Tₜₑₛₜ) sont alimentés de manière similaire avec un courant de test à partir d'une source de courant constant (10) ou à partir d'un circuit intermédiaire à tension continue (ZK) via une résistance (R).
